# EUROPEAN PATENT APPLICATION

(11) **EP 4 807 858 A1**
(43) Date of publication of application: **16.09.2026**
(21) Application number: 25163421.8
(22) Date of filing: 13.03.2025
(51) Int. Cl.: H01M 10/625, G01R 31/389, G01R 31/392, H01M 10/633

(54) **METHOD OF PREDICTING THERMAL RUNAWAY**

(71) Applicant: NXP B.V., 5656 AG Eindhoven (NL)
(72) Inventor: Vos, Levi, 5656 AG Eindhoven (NL); van Mierlo, Cis, 5656 AG Eindhoven (NL); Bergveld, Hendrik Johannes, 5656 AG Eindhoven (NL); van Loo, InSun, 5656 AG Eindhoven (NL); Prochazka, Wenzel, 5656 AG Eindhoven (NL)
(74) Representative: Schmütz, Christian Klaus Johannes

(57) **Abstract**

The present disclosure relates to a method of providing an early warning of thermal runaway in a battery cell, the method comprising: monitoring, over time, a temperature of the battery cell; monitoring, over time, a real part of an impedance of the battery cell for a plurality of test signal frequencies by: applying a plurality of test signals to the battery cell at each of a plurality of discrete time intervals, each of the plurality of test signals having a corresponding one of the plurality of test signal frequencies; and determining, for each applied test signal, the real part of the impedance of the battery cell; determining, over time, whether the temperature of the battery cell is increasing; determining, over time, whether the real parts of the impedances corresponding to the plurality of test signal frequencies have converged; and providing a first warning if the real parts of the impedances at the plurality of test signal frequencies have converged and the temperature has been increasing for a first predetermined number of the discrete time intervals.

## Description

### Field

The present disclosure relates to a method of predicting thermal runaway. In particular, the present disclosure relates to a method of predicting thermal runaway in a battery cell by identifying trends in the real impedance of the battery cell and the temperature of the battery cell over time.

### Summary

According to a first aspect of the present disclosure there is provided a method of providing an early warning of thermal runaway in a battery cell, the method comprising:
monitoring, over time, a temperature of the battery cell;
monitoring, over time, a real part of an impedance of the battery cell for a plurality of test signal frequencies by:
   applying a plurality of test signals to the battery cell at each of a plurality of discrete time intervals, each of the plurality of test signals having a corresponding one of the plurality of test signal frequencies; and
   determining, for each applied test signal, the real part of the impedance of the battery cell;
determining, over time, whether the temperature of the battery cell is increasing;
determining, over time, whether the real parts of the impedances corresponding to the plurality of test signal frequencies are converging; and
providing a first warning if the real parts of the impedances at the plurality of test signal frequencies have converged and the temperature has been increasing for a first predetermined number of the discrete time intervals.

In one or more embodiments, the method further comprises:
after providing the first warning, determining, over time, whether the real parts of cell impedances corresponding to the plurality of test signal frequencies are increasing; and
providing a second warning if the real parts of cell impedances corresponding to the plurality of test signal frequencies have been increasing and the temperature has been increasing for a second predetermined number of the discrete time intervals.

In one or more embodiments, the method further comprises:
determining, over time, whether the real parts of cell impedances corresponding to the plurality of test signal frequencies are increasing by determining derivatives, with respect to time, of the real parts of the impedances corresponding to each of the plurality of test signal frequencies; and
providing a second warning if the derivatives, with respect to time, of the real parts of the impedances corresponding to each of the plurality of test signal frequencies have been greater than zero and the temperature has been increasing for a second predetermined number of the discrete time intervals.

In one or more embodiments, the method further comprises:
determining plurality of test signal frequencies by:
determining an impedance response of a reference battery cell, the impedance response defining an impedance of the reference battery cell at a plurality of signal frequencies; and
selecting, based on the impedance response, the plurality of test signal frequencies comprising:
   a reference frequency corresponding to a frequency at which the imaginary part of the impedance response of the reference cell is approximately zero; and
   one or more additional signal frequencies, the one or more additional frequencies being lower in frequency than the first reference frequency.

In one or more embodiments, the one or more additional frequencies of the plurality of test signal frequencies are frequencies characteristic of a semi-circle region on a Nyquist plot of the impedance response of the reference battery cell.

In one or more embodiments, the one or more additional frequencies of the plurality of test signal frequencies comprise three or more distinct frequencies.

In one or more embodiments, determining an impedance response of the reference battery cell comprises performing an electrochemical impedance spectroscopy, EIS, analysis on the reference battery cell.

In one or more embodiments, monitoring, over time, the real part of the impedance of the battery cell for each of the plurality of test signal frequencies comprises:
applying the plurality of test signals to the battery cell at a plurality of discrete time intervals, the plurality of test signals having the plurality of test signal frequencies;
determining the real part of an impedance corresponding to a reference frequency; and
determining the real part of one or more impedances corresponding to the one or more additional frequencies; and
wherein determining, over time, whether the real parts of the impedances corresponding to the plurality of test signal frequencies have converged comprises:
determining, at each discrete time interval, a mean average of the differences between the real part of the impedance corresponding to the reference frequency and the real part of the one or more impedances corresponding to the one or more additional frequencies; and
wherein the method comprises providing the first warning if the mean average is approximately constant or increasing over time while the temperature has been increasing for a first predetermined number of the discrete time intervals.

In one or more embodiments, monitoring, over time, a real part of an impedance of the battery cell for each of a plurality of test signal frequencies comprises:
applying the plurality of test signals to the battery cell at a plurality of discrete time intervals, the plurality of test signals having the plurality of test signal frequencies;
**determining** the real part of an impedance corresponding to a reference frequency; and
determining the real part of one or more impedances corresponding to the one or more additional frequencies; and
wherein determining, over time, whether the real parts of the impedances corresponding to the plurality of test signal frequencies have converged comprises:
determining, for each discrete time interval, a derivative with respect to time of the mean average of the differences between the real part of the impedance corresponding to the reference frequency and the real part of the one or more impedances corresponding to the one or more additional frequencies; and
wherein the method comprises providing the first warning if the derivative has risen above a threshold value and the temperature has been increasing for a first predetermined number of the discrete time intervals.

In one or more embodiments, the threshold value is a small negative value, "-epsilon", i.e. -*ε*. In one or more embodiments the threshold value, -*ε*, is close to zero.

In one or more embodiments, monitoring, over time, the temperature of the battery cell comprises monitoring an external temperature of the battery at the plurality of discrete time instances.

In one or more embodiments, monitoring an external temperature of the battery at the plurality of discrete time instances comprises using measurements from one or more negative temperature coefficient thermistors, NTCs.

In one or more embodiments, determining, over time, whether the temperature of the battery cell is increasing by determining a derivative with respect to time of the monitored temperature of the battery cell.

According to a further aspect of the present disclosure there is provided a battery management system, BMS, for managing one or more battery cells, comprising circuitry and/or one or more hardware modules configured to perform any method disclosed herein on at least one battery cell.

In one or more embodiments, the battery management system, BMS, comprises:
a potentiostat or galvanostat configured to apply the plurality of test signals to the one or more battery cells;
a thermal management module configured to monitor the temperature of the one or more battery cells; and
circuitry configured to perform the method of any preceding claim.

According to a further aspect of the present disclosure there is provided a non-transitory computer-readable medium encoding instructions operable to cause a battery management system, BMS, to perform any method of the present disclosure.

According to a further aspect of the present disclosure there is provided a vehicle comprising any battery management system and/or the non-transitory computer-readable medium disclosed herein.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

### Brief Description of the Drawings

One or more embodiments will now be described by way of example only with reference to the accompanying drawings in which:
Figure 1 is a block diagram illustrating a method of providing an early warning of thermal runaway in a battery cell;
Figure 2 is an example Nyquist plot showing an impedance response of a battery cell for a plurality of signal frequencies;
Figure 3a is a graph showing a variation, with temperature, of a difference between the real part of the impedance of a battery cell at a reference frequency and the real part of the impedance at each of three different sample frequencies;
Figure 3b is a graph showing a variation, with temperature, of a first-order derivative, with respect to time, of the data shown in Figure 3a;
Figure 4 shows another example of a Nyquist plot of an impedance response of a battery cell for a plurality of signal frequencies;
Figure 5 is a graphical representation of the variation, over time, of the real part of an impedance of a battery cell due to the effects of temperature and gas bubbles in the battery cell;
Figure 6 is a flowchart illustrating an example implementation of a method of providing an early warning of thermal runaway in a battery cell;
Figure 7 is a graphical representation of an example method of providing an early warning of thermal runaway;
Figure 8a is a graph of external temperature, against time, for a battery cell that was subjected to overheating for a period of time;
Figure 8b is a graph of the real part of the impedance, against time, for the same battery cell across the same period of time as shown in Figure 8a;
Figure 9a illustrates a graph of external temperature, against time, for a battery cell that was subjected to overcharging for a period of time;
Figure 9b illustrates a graph of the real part of the impedance, against time, for the same battery cell across the same period of time as shown in Figure 9a; and
Figure 10 is a schematic diagram of a battery management system, BMS, for managing one or more battery cells.

### Detailed Description

As the world is transitioning to more sustainable alternatives, Electric Vehicles (EV) are becoming more mainstream. By 2030 automotive vehicle manufacturers are expected to transition from using an internal combustion engine to electric-driven vehicles powered by Lithium-ion (Li-ion) battery packs for cars, trucks, and buses. Such battery packs contain hundreds of Li-ion cells that each need to be monitored. However, the Lithium-ion-based batteries that are used to power those EVs can become unstable if not managed properly. Slowly developing faults in these cells may affect battery pack performance, and can even lead to serious safety concerns, such as thermal runaway. Thermal runaway is an extreme outcome if the battery pack is not managed properly. This does happen in practice - in the US, EVs caught fire at a rate of 25.1 per 100,000 sales (according to a study in 2022).

Early prediction of thermal runaway could ideally be used to prevent / stop thermal runaway. Even if the oncoming thermal runaway event cannot be prevented, an early-warning system is required to allow passengers to leave the vehicle safely. Prediction of thermal runaway can involve using negative-temperature-coefficient thermistor (NTC) measurements and voltage measurements. However, early prediction of thermal runaway with a high reliability has proven to be difficult with the current hardware alone. A problem is that NTC's are local solutions situated at the outside of the cell. Particularly in cases where a battery experiences rapid heating, such as during fast charging, and/or when the batteries are actively cooled, the temperature gradient formed can be great and the NTC will not rapidly detect an inner temperature of the battery cell. A delay in detecting a dangerously high inner temperature of the battery cell can lead to thermal runaway.

To address these issues, it is an object of the present disclosure to provide a technique which can gain insights to the cells internals and to design an identifier based on a sequence of physical events that will occur before thermal runaway occurs in a Lithium-ion cell.

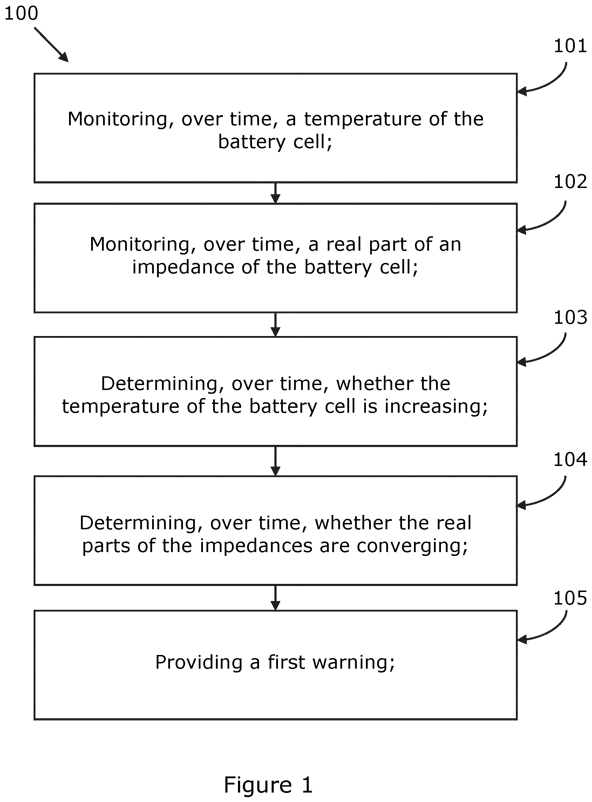

Figure 1 is a block diagram illustrating a method 100 of providing an early warning of thermal runaway in a battery cell. It should be understood that the order in which the steps of the method are performed may vary from the order presented in Figure 1.

Beneficially, the method of Figure 1 provides a first "early" warning of thermal runaway based on identifying trends over time in the external temperature of the battery cell in combination with trends over time in the real part of impedances of the battery cell at a plurality of different frequencies. The trends over time in the real part of impedances of the battery cell at a plurality of different frequencies can be indicative of the internal temperature of the battery cell. By monitoring said trends, thermal runaway can be predicted, and a warning can be provided at an earlier stage than previous thermal-runaway warning systems have been able to provide. In specific embodiments, trends in the real part of the impedances at the plurality of different frequencies may be monitored by determining an average of the absolute differences between the real impedance at a reference frequency and one or more additional frequencies. Monitoring the impedance using said average real absolute difference mitigates the effects of any changes in state of charge or state of health of the battery cell, and therefore the average real absolute difference can be considered as more accurately linked to the battery cell internal temperature.

The method comprises monitoring 101, over time, a temperature of the battery cell. In particular, an external temperature of the battery cell can be monitored using negative-temperature-coefficient thermistors, NTCs, positioned on or proximate to the battery cell. To monitor the temperature over time, the temperature can be measured at a plurality of discrete points in time, that is, at a plurality of discrete time intervals which may be regular intervals.

The method further comprises monitoring 102, over time, a real part of an impedance of the battery cell for a plurality of test signal frequencies by: applying a plurality of test signals to the battery cell at each of the plurality of discrete time intervals, each of the plurality of test signals having a corresponding one of the plurality of test signal frequencies; and determining, for each applied test signal, the real part of the impedance of the battery cell. As will be further described below, said steps may be achieved using electrochemical-impedance-spectroscopy techniques. It will be appreciated that the monitoring at steps 101 and 102 may be performed at the same time or in either order.

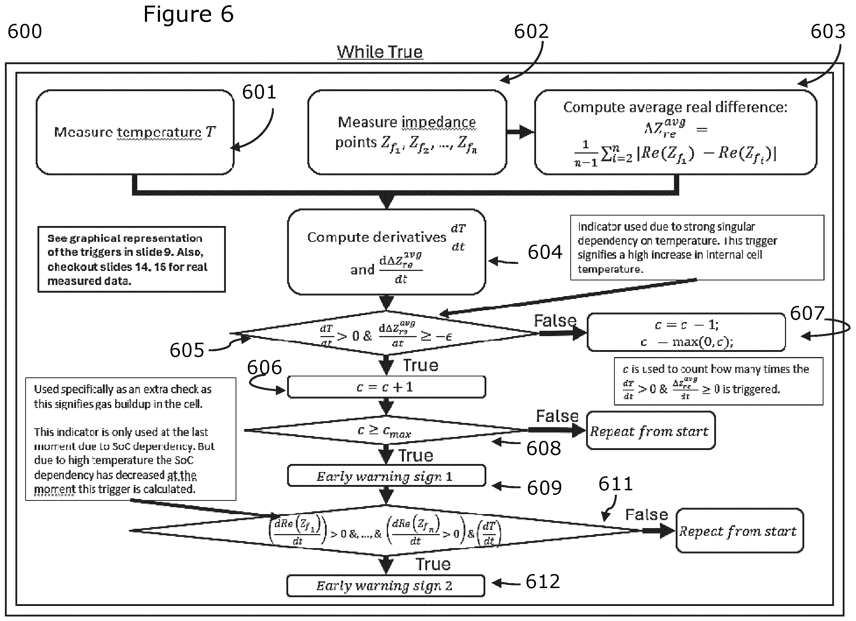

The method further comprises determining 103, over time, whether the temperature of the battery cell is increasing. As will be described below in relation to the implementation described with reference to Figure 6, this may be achieved by determining a derivative, with respect to time, of the monitored temperature of the battery cell. The derivative may be calculated for each discrete time interval using standard mathematical techniques.

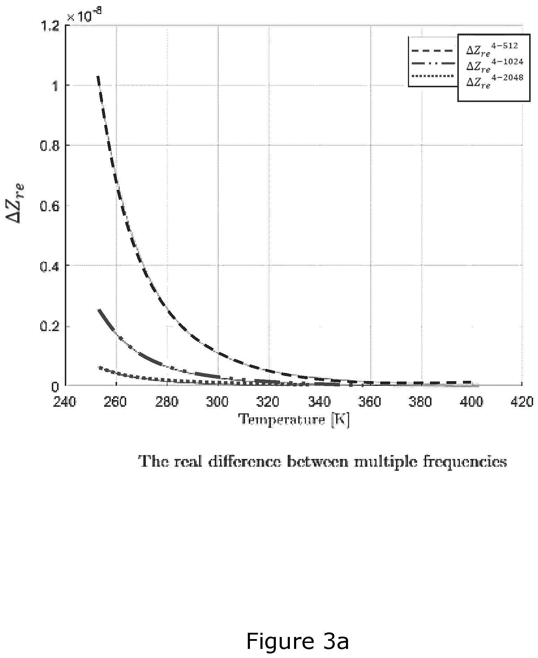

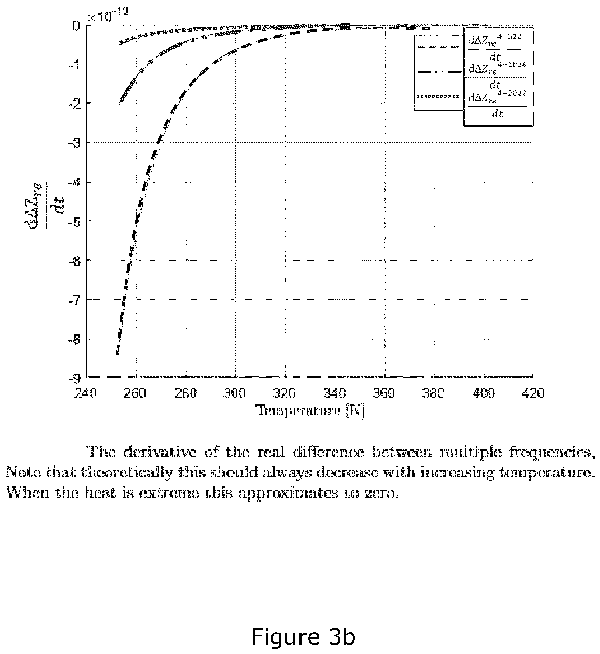

The method further comprises determining 104, over time, whether the real parts of the impedances corresponding to the plurality of test signal frequencies have converged. As will be described below with reference to Figure 3a, the convergence of the real parts of the impedances corresponding to the plurality of test signal frequencies may be determined by determining whether an average difference, between the real impedance of the battery cell at a reference frequency and the real impedance of the battery cell at a plurality of other frequencies, is approximately constant. Alternatively, as will be described below with reference to Figure 3b and an implementation of the method described with reference to Figure 6, the convergence of the real parts of the impedances corresponding to the plurality of test signal frequencies may be determined by determining whether a derivative, with respect to time, of the real average difference, has risen above a reference value. The reference value may also be referred to as a threshold value. As will be described below, the reference value is a negative value.

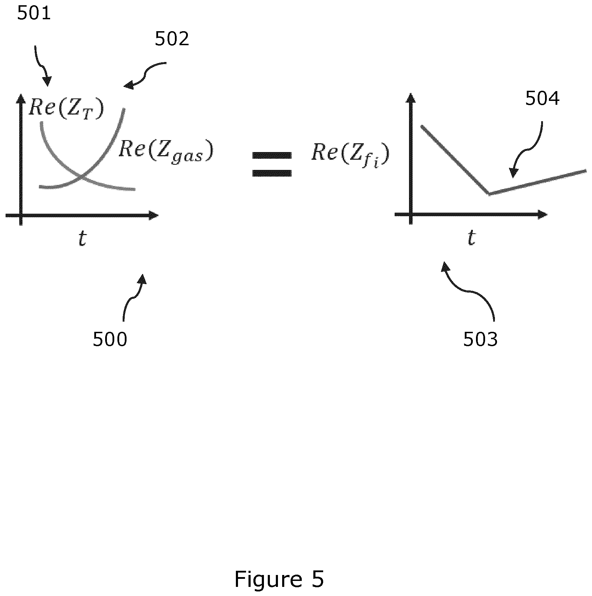

The method further comprises providing 105 a first warning if the real parts of the impedances at the plurality of test signal frequencies have converged and the temperature has been increasing for a first predetermined number of the discrete time intervals. That is, if the external temperature of the battery cell is increasing and the real parts of the impedances at the plurality of test signal frequencies have converged, then this is indicative of the battery cell temperature increasing in such a way that is indicative of thermal runaway being likely to occur. Accordingly, the method of Figure 1 advantageously provides an early warning, for example to an operator of an electric vehicle powered by the monitored battery cells, before thermal runaway occurs. As will be described below with reference to Figure 5, the method may additionally provide a second warning, subsequent to the first warning, when it is determined that the trends in the real impedances of the battery cell at the plurality of frequencies have reversed. The second warning provides a further opportunity to warn an operator before thermal runaway occurs.

In an embodiment, monitoring 102, over time, a real part of an impedance of the battery cell for a plurality of test signal frequencies comprises performing electrochemical impedance spectroscopy, EIS, on the battery cell for the plurality of test signal frequencies. To perform EIS on a battery cell, typically a sinusoidal voltage or current signal is applied to the battery cell over a range of frequencies. This signal perturbs the system slightly without significantly altering its state. The perturbing current or voltage signal as well as the resulting voltage or current, respectively, response of the battery cell are measured. The response is recorded over a wide frequency range, typically from a few millihertz to several kilohertz. The measured data can be used to construct an impedance response, which may be represented as a Nyquist plot. A Nyquist plot shows the real part of the impedance on the x-axis and the negative imaginary part on the y-axis. The impedance spectrum can be analysed to identify different physical processes occurring within the battery cell.

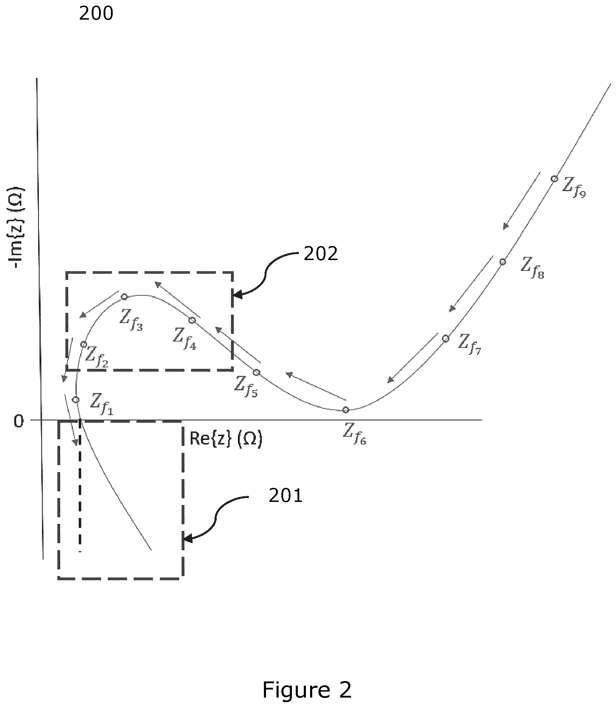

Figure 2 is an example Nyquist plot 200 showing an impedance response of a battery cell for a plurality of signal frequencies. The impedance response shown by the Nyquist plot 200 is typical of a Lithium-ion battery cell used in battery packs for electric vehicles. Such a plot can be obtained by performing electrochemical impedance spectroscopy on the battery cell as described above with reference to Figure 1. A plurality of points Z_{f1} - Z_{f9} representing the impedance, Z, of the battery cell at nine different frequencies, f₁-f₉, are plotted on the set of axes, where the x axis is the real axis and the y axis is the negative imaginary axis. Lower frequencies appear on the top right-hand side of the plot, and higher frequencies on the bottom left-hand side. That is, in Figure 2, the impedance point labelled Z_{f9} is the point corresponding to the lowest frequency of the frequencies f₁-f₉ and impedance point Z_{f1} is the point corresponding to the highest frequency of the frequencies f₁-f₉.

The Nyquist plot 200 further illustrates the effects of temperature on the impedance of the battery cell at the plurality of frequencies. The arrows illustrated in Figure 2 show that as the battery cell heats up, the frequency points on the Nyquist plot 200 move from top-right to bottom-left on the curve. This behaviour results in the convergence of impedance points along the real axis towards a minimum real impedance value. Furthermore, this behaviour results in a lower frequency at which the imaginary part of the impedance of the battery cell is zero, which may also be referred to as the zero-intercept frequency.

An inductive region 201 of the Nyquist plot 200 with positive imaginary impedance values can be modelled ideally as a straight line downwards. However, in empirical measurements, the inductive region 201 slopes to the right, for example due to magnetic coupling effects. Therefore, the difference between two impedance points might first converge closer to each other and after some temperature increase then diverge from each other, as the points move along the Nyquist curve in the inductive quadrant. For example, consider two impedance points, a first corresponding to a higher frequency and a second corresponding to a lower frequency. As the battery cell heats up, the two frequency points will move along the Nyquist curve as shown by the arrows in Figure 2 and the real parts of the impedance points will converge towards a minimum real impedance value. As the battery cell continues to heat up, the higher frequency moves in the inductance tail which results in the real part of the impedance point corresponding to the higher frequency being greater than the real part of the impedance point corresponding to the lower frequency. In other words, the difference between two points, Re(fᵢ), Re(fⱼ) | (fᵢ>fⱼ) and Re(fᵢ) > Re(fⱼ)), might first converge closer to each other and after some temperature increase start to diverge from each other, as the points move along the Nyquist curve in the inductive quadrant. This will occur when the higher frequency fᵢ moves in the inductance tail which results in Pe(fᵢ) > Re(fⱼ).

**Besides** the frequency points travelling along the curve, as the battery cell heats up the curve also scales to lower impedance values, resulting in a curve that is tilted to the left, because lower frequencies are more sensitive to temperature changes than higher frequencies. This results in compression of a semi-circle region of the Nyquist plot as the battery cell heats up. The scaled curve is not depicted in Figure 2.

The semi-circle region 202 of the Nyquist plot 200 is approximately defined by the box with dashed lines provided in Figure 2. When the Nyquist curve slopes to the left as the battery cell heats up, not shown, the impedance points situated to the left of the semi-circle region 202 converge faster than those situated to the right of the semi-circle region 202.

Accordingly, to capture all these effects, the inventors have found that the real impedance convergence, i.e. $\frac{d {ΔZ}_{Re}^{avg}}{dt} \geq - ϵ$, of multiple points on the semi-circle region 202 towards the impedance point with the minimum real impedance is indicative of battery cell heating and that this can be utilised in a provide a first early warning of thermal runaway. When this trend stops or reverses while the battery cell is still heating up, it is a clear sign that the limits of the model are breaking down. For this reason, in some embodiments the real impedance divergence and/or increase while the temperature increases *dT*/*dt>0* can be used to provide a second early warning of thermal runaway. This is a clear indicator of extreme internal heating of the battery cell. This combination is a clear indicator that the battery cell will go in thermal runaway if no actions are taken and therefore can be used as an early-warning indicator.

Impedance, over time, of a battery cell can be defined as a function of time, the frequency of the signal applied to the battery cell, temperature of the battery cell, the state of charge, SoC, of the battery cell and the state of health, SoH, of the battery cell. Algebraically, this can be written as: $Z \left(t\right) = Z \left(t, f, T, SoC, SoH\right)$

However, for the purposes of predicting thermal runaway, Z(t) can simplified. Thermal runaway needs to be predicted in a relatively short time span, for example in the order of ten seconds to a few minutes. Over such a short time span, any change in the state of health of the battery cell is negligible. Furthermore, the battery cell impedance is least dependent on the state of charge and the state of health of the battery cell at the zero-intercept frequency, and at higher frequencies. Therefore, the impedance primarily depends on temperature at these frequencies. Even though at the zero-intercept frequency the effect of the state of charge is less significant than at lower frequencies, it still can be a relatively large contributing factor when looking at a single frequency. However, the difference between impedance values, particularly the real parts of the impedance, are almost constant over the entire state of charge region, thereby reducing the dependence of state of charge on Z(t) even more. Also important to note is that the dependence of Z(t) on state of charge decreases with increasing temperature.

Therefore, we can simplify the impedance as follows: $Z \left(t\right) = Z \left(t, f, T\right)$

For the reasons indicated, in an example embodiment of the present disclosure, a difference in the real part of the impedance at different sets of two frequencies is used: $Δ {Z}_{re}^{i} = \left|Re\left(Re\left(Z\left(t, {f}_{1}, T\right)-Re\left(t, {f}_{i}, T\right.\right)\right.\right|$

The difference in real impedance at the zero-intercept frequency and another frequency is strongly dependent on temperature and the dependence on state of charge and state of health is minimized.

Figure 3a is a graph showing a variation, with temperature, of an absolute difference, "ΔZᵣₑ", between the real part of the impedance of a battery cell at a reference frequency and the real part of the impedance at each of three different sample frequencies.

The cause of thermal runaway can be diverse, so the inventors have developed an identifier that is robust against these different causes. Whatever the cause of thermal runaway in a battery cell, the common denominator in the result is that the battery cell is heating up. Looking to Figure 3a, showing the variation of ΔZᵣₑ with temperature for three different sample frequency values, it can be seen that as battery cell temperature increases, all of the ΔZᵣₑ values converge towards a minimum real impedance difference. In this example, the ΔZᵣₑ values converge towards zero. When the battery cell cools, ΔZᵣₑ diverges.

Figure 3b is a graph showing a variation, with temperature, of a first-order derivative, with respect to time, of the data shown in Figure 3a. Figure 3b shows that as temperature increases, the derivative of the absolute difference is negative and increasing to smaller negative values. Therefore, when the derivative, with respect to time, of an absolute difference between the real part of the impedance of a battery cell at a reference frequency and the real part of the impedance at another frequency has risen above a reference value, which may also be referred to as a threshold value, which for example has a small negative value "-*ε*", this is indicative of whether the real parts of the impedances have converged and therefore indicative of extreme rising internal temperature within a battery cell.

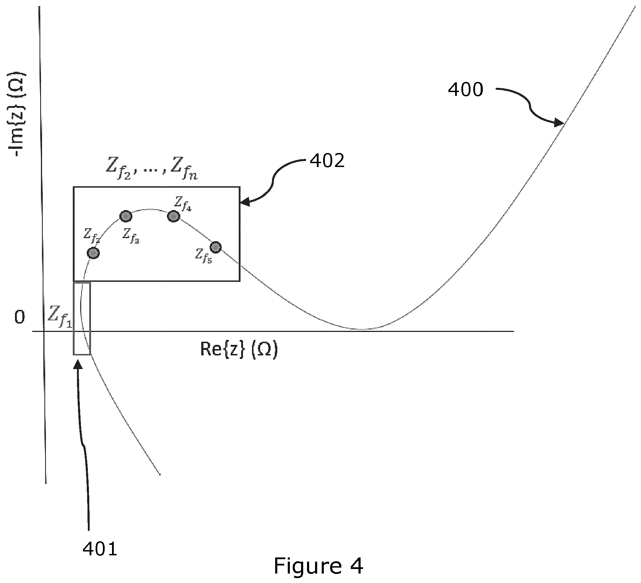

Figure 4 shows another example of a Nyquist plot of an impedance response of a battery cell for a plurality of signal frequencies. Such a plot can be obtained by performing an electrochemical-impedance-spectroscopy analysis on the battery cell as discussed above in relation to Figure 1.

The method discussed above in relation to Figure 1 may further comprise determining the plurality of test signal frequencies by determining an impedance response of a reference battery cell at a reference temperature such as room temperature, the impedance response defining an impedance of the reference battery cell at a plurality of signal frequencies, and selecting, based on the impedance response, the plurality of test signal frequencies. The reference battery cell may be a Lithium-ion battery cell used in battery packs for electric vehicles. The impedance response of the reference cell is determined in conditions in which the reference cell is not subject to heating.

For example, the measurements performed on the reference cell to determine the impedance response of the reference cell may be carried out at room temperature and/or in controlled conditions. Where the method discussed above in relation to Figure 1 is to be used to provide an early warning of thermal runaway for a particular model of battery cell in a battery pack of an electric vehicle, it can be advantageous for the reference battery cell to be a battery cell of identical or similar model.

In this example, the plurality of test signal frequencies includes a reference frequency, Z_{f1}, corresponding to a zero-intercept frequency, i.e. frequency at which the imaginary part of the impedance response of the reference cell is approximately zero. The reference frequency f₁ may be determined by selecting a corresponding reference impedance point, Z_{f1}, which should be in the global minimum region 401 which indicates the global minimum of real impedance and is the region at which the imaginary part of the impedance is approximately zero. The plurality of test signal frequencies also includes one or more additional signal frequencies, which are lower in frequency than the reference frequency. The one or more additional frequencies are frequencies characteristic of a semi-circle region 402 on the Nyquist plot of the reference battery cell at the reference temperature. In other words, the one or more additional frequencies are frequencies corresponding to impedance points on the Nyquist plot 400 that correspond to the semi-circle region 402 of the Nyquist plot. The one or more additional frequencies may comprise any number of frequencies. In preferred embodiments, the one or more additional frequencies comprise three or more distinct frequencies. In this example, the one or more additional frequencies comprise four distinct frequencies corresponding to impedance points Z_{f2} - Z_{f5}.

Figure 5 is a graphical representation of the variation, over time, of the real part of an impedance of a battery cell due to the effects of temperature of the battery cell and gas bubbles in the battery cell. Figure 5 shows a first graph 500 illustrating a first plot 501, which represents the variation of the impedance of the battery cell over time due to the effects of increasing battery cell temperature with time. Figure 5 also shows a second plot 502, which represents the variation of the impedance of the battery cell over time due to the effects of gas bubbles being produced within the battery cell. Figure 5 shows a second graph 503 illustrating a plot 504 representative of the combination of the plots shown in the first graph 500. That is, Re(Z*_{fi}*) = *Re*(*Z_{T}*) + *Re*(*Z_{gas}*)*.*

The gas bubbles are a physical precursor to a battery cell failure event. When the internal temperature of a battery cell reaches a certain limit and/or when the state of charge is too high in certain regions of the cell due to the gradients inflicted by charging or cooling, gas is generated between the electrodes and the diffusion of Lithium ions through the cell is limited by the gas bubbles. Accordingly, the active electrode area is reduced, and the cell impedance rises. As the temperature increases further, the effect of increasing temperature leading to lower impedance becomes less significant and the effect of the gas bubbles on the impedance increases, which leads to slower diffusion and lower available active area. This combined effect of rising temperature and gas evolution limiting reaction speeds becomes visible when the real impedance at a certain frequency curves upwards and starts increasing, i.e dRe(Z_{fi})/dt > 0, while the temperature increases, i.e. dT/dt > 0. This is generally observed around the point in time when swelling of the battery cell can be detected, and well before the thermal runaway occurs. This is a clear indicator of abnormal behavior in the battery cell that indicates that a thermal runaway might occur if no actions are taken.

Accordingly, the method described above in relation to Figure 1 may further comprise, after providing the first warning, determining, over time, whether the real parts of cell impedances corresponding to the plurality of test signal frequencies are increasing. A second warning may be provided if the real parts of cell impedances corresponding to the plurality of test signal frequencies have been increasing and the temperature has been increasing for a second predetermined number of the discrete time intervals. This is illustrated in Figure 6, and will be described in more detail with reference to the figure.

Figure 6 is a flowchart illustrating an example implementation of a method of providing an early warning of thermal runaway in a battery cell.

The method comprises measuring 601, or monitoring, over time, a temperature of the battery cell. In this example, measuring the temperature of the battery cell over time comprises measuring the external temperature at a plurality of discrete time instances. Monitoring the external temperature of the battery cell at the plurality of discrete time instances comprises using measurements from one or more negative-temperature-coefficient thermistors, NTCs.

The method further comprises measuring 602, or monitoring, over time, the impedance of the cell at the plurality of test signal frequencies. The plurality of test signal frequencies is determined as described above with reference to Figure 4 by determining a reference frequency and one or more additional frequencies at a reference temperature where no heating has taken place, such as room temperature. In this example, monitoring, over time, the real part of the impedance of the battery cell for each of the plurality of test signal frequencies comprises: i) applying the plurality of test signals to the battery cell at a plurality of discrete time intervals, the plurality of test signals having the plurality of test signal frequencies, ii) determining the real part of an impedance corresponding to a reference frequency, and iii) determining the real part of one or more impedances corresponding to the one or more additional frequencies.

The method determines 603 an average absolute real difference between the real part of the impedance at the reference frequency and the real parts of the impedances at the one or more additional frequencies. The average absolute real difference may, in other words, be referred to as a mean average of the absolute differences between the real part of the impedance corresponding to the reference frequency and the real part of the one or more impedances corresponding to the one or more additional frequencies, and may be mathematically expressed using the following expression: $Δ {Z}_{Re}^{avg} = \frac{1}{n - 1} {\sum }_{i = 2}^{n} \left|Re\left({Z}_{f 1}\right)-Re\left({Z}_{fi}\right)\right|$

The method further determines, over time, whether the temperature of the battery cell is increasing by determining 604 a derivative with respect to time of the temperature of the battery cell, dT/dt. The method further determines, over time, whether the real parts of the impedances corresponding to the plurality of test signal frequencies have converged by determining 604 a derivative with respect to time of the average real absolute difference between the reference frequency, f₁ and each of the one or more additional frequencies. That is, the method determines 604 a derivative with respect to time of $Δ {Z}_{Re}^{avg}$*.*

The method further comprises determining 605, for each discrete time interval, whether the temperature of the battery cell has increased by determining if a derivative with respect to time of the temperature of the battery cell is greater than zero. The method further comprises determining 605, for each discrete time interval, whether the real parts of the impedances have converged by determining whether the derivative with respect to time of the average real absolute difference between the reference frequency and each of the one or more additional frequencies has risen above a reference value, which may also be referred to as a threshold value. In this example, the reference value is a predefined small negative value, -*ε*, that is close to zero. As described above in relation to Figure 3b, said determination is indicative of whether the real parts of the impedances have converged. Said determination may be thought of, or alternatively described, as determining whether the average real absolute difference, that is, the mean average of the absolute differences between the real part of the impedance corresponding to the reference frequency and the real part of the one or more impedances corresponding to the one or more additional frequencies, is approximately constant or increasing while the temperature is increasing, as described above in relation to Figure 3a.

If both of the determined criteria are true for a discrete time interval, the method comprises incrementing 606 a counter variable, c, by 1. If either or both of those criteria are false, the method comprises decrementing 607 the counter variable by 1. The method further comprises, for each discrete time period, comparing 608 the value of the counter variable, c, to a predetermined threshold value (cₘₐₓ in Figure 6). If the counter variable has reached or exceeds the predetermined threshold value, the method comprises providing 609 a first warning. If the counter variable is less than the predetermined threshold value, the process repeats for the next discrete time interval.

After providing 609 the first warning, the method comprises determining 611, for each discrete time interval, whether the temperature of the battery cell has increased by determining if the derivative with respect to time of the temperature of the battery cell is greater than zero. The method further comprises determining 611, for each discrete time interval, whether the real parts of cell impedances corresponding to the plurality of test signal frequencies are increasing by determining if the derivatives with respect to time of the real parts of the impedances corresponding to each of the plurality of test signal frequencies is greater than zero. If both of those criteria are true, the method comprises providing 612 a second warning.

The method as described in relation to Figure 6 may alternatively be described by the steps presented below:
- Electrochemical Impedance Spectroscopy (EIS) to gather information on the internal state of the battery cell at specific frequencies.
- Determine the most suitable EIS frequency points for a reference cell at a reference temperature where no heating occurs to represent the semi-circle (*f*₂*,* ..., *fₙ*) and one frequency as reference for the other frequencies (*f*₁) such that *f*₁ > {*f*₂, ..., *fₙ*}*.*
- Determine the real part of the measured impedance at n distinct frequencies: *Re*(*Z*_{*f*₁})*, Re*(*Z*_{*f*₂})*, ..., Re*(*Z_{fₙ}*) and calculate the absolute difference between each point to the reference point: $Δ {Z}_{re}^{i} = \left|Re\left({Z}_{{f}_{1}}\right)-\right.$ *Re*(*Z_{fᵢ}*)|*.*
- Calculate the average real absolute difference $Δ {Z}_{re}^{avg} = \frac{1}{n - 1} {\sum }_{i = 2}^{n} Δ {Z}_{re}^{i}$
- Measure the external cell temperature T (note: T internal is >> T external) and compare $\frac{dT}{dt}$ to $\frac{dΔ {Z}_{re}^{avg}}{dt}$.
- When the average difference impedance rises $\frac{dΔ {Z}_{re}^{avg}}{dt} \geq - ε$ while the temperature increases $\frac{dT}{dt} > 0$ the thermal runaway counter variable is incremented *c* = c + 1 (c starts at 0).
- When c is above some threshold *cₘₐₓ* the first thermal-runaway detection sign is triggered.
- If the trend $\frac{dΔ {Z}_{re}^{avg}}{dt} \geq - ε , \frac{dT}{dt} > 0$ is not reversed the event will keep triggering. If during the activation of this trend the real impedance of all impedance points increases $\frac{dRe \left({Z}_{{f}_{1}}\right)}{dt} > 0 & \frac{dRe \left({Z}_{{f}_{2}}\right)}{dt} > 0 & … \frac{dRe \left({Z}_{{f}_{n}}\right)}{dt} > 0$ while the temperature is still increasing, a second thermal-runaway detection sign is triggered.
- Two independent sensors (NTC and EIS) are used to signal an early warning for thermal runaway; therefore, the method conforms with ASIL, automotive safety integrity level, rules of decomposition of safety to reach the needed ASIL levels in batteries (C/D).

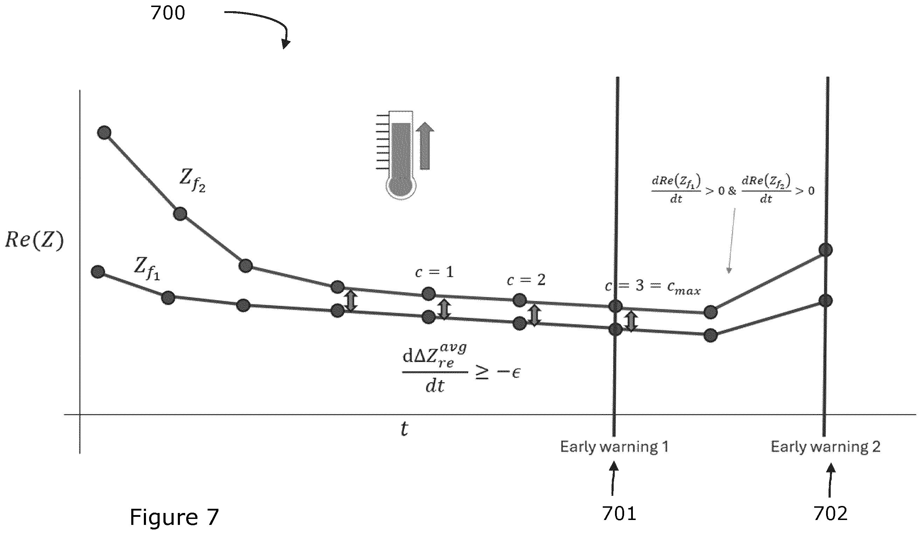

Figure 7 is a graphical representation 700 of an example method of providing an early warning of thermal runaway. The x axis of Figure 7 measures time and the y axis of Figure 7 measures the real part of the impedance, Z, of an example battery cell. In this example, the method comprises monitoring, over time, the impedance of the battery cell for a test signal at a reference frequency, Z_{f1}, and monitoring, over time, the impedance of the battery cell for a test signal at one additional frequency, Z_{f2}. Additionally, the method comprises monitoring, over time, the temperature of the battery cell.

In this example, the method comprises determining a derivative, with respect to time, of the average real absolute difference between Z_{f1} and Z_{f2}. The derivative of the average real absolute difference may be calculated as described above in relation to Figure 6. The value of a counter variable, c, is incremented when the derivative, with respect to time, of the average real absolute difference between Z_{f1} and Z_{f2} is greater than or equal to a reference value. In this example, the value of the counter variable, c, is incremented when the derivative, with respect to time, of the average absolute real difference between Z_{f1} and Z_{f2} is greater than or equal to a predefined small negative value, "-*ε*". When the value of the parameter c is equal to a predefined threshold value, cₘₐₓ, a first warning 701 is provided.

After the provision of the first warning 701, the trend in the real part of the impedance "reverses". The method comprises determining a derivative, with respect to time, for each of the real impedances. The method further comprises providing a second warning 702 if the temperature of the battery cell is increasing and both of the derivatives with respect to time of Z_{f1} and Z_{f2} are greater than zero.

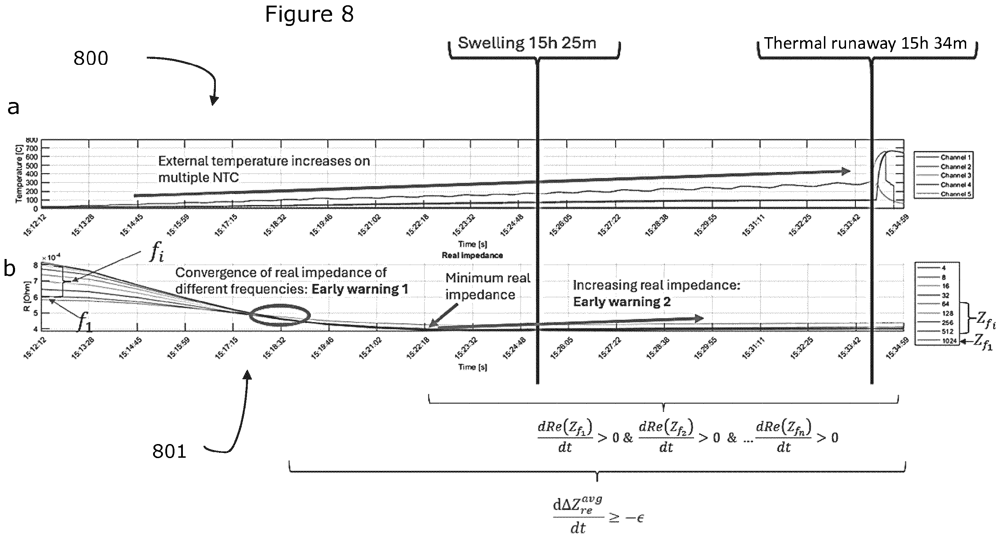

Figure 8a illustrates a graph 800 of external temperature, against time, for a battery cell that was subjected to overheating for a period of time. The graph 800 shows the temperature measured by a plurality of negative-temperature-coefficient thermistors, NTCs, each configured to measure an external temperature of the battery cell. The battery cell was overheated to push the battery cell into thermal runaway. The graph 800 in Figure 8a shows that the temperature of the battery cell increases with time.

Figure 8b illustrates a graph 801 of the real part of the impedance, against time, for the same battery cell across the same period of time as shown in Figure 8a. The graph 801 in Figure 8b shows that the real parts of the impedance of the battery cell at each of the different frequencies converge with time. The convergence triggers a first early warning of thermal runaway. The real parts of the impedances converge to a minimum real impedance. Shortly after the convergence of the real impedances to the minimum real impedance, swelling of the battery cell occurs (as observed with a high-speed camera during the experiments). Subsequent to the first early warning, the real parts of the impedances increase, triggering a second early warning of thermal runaway. Some time after the second early warning, the graph in Figure 8a shows thermal runaway taking place.

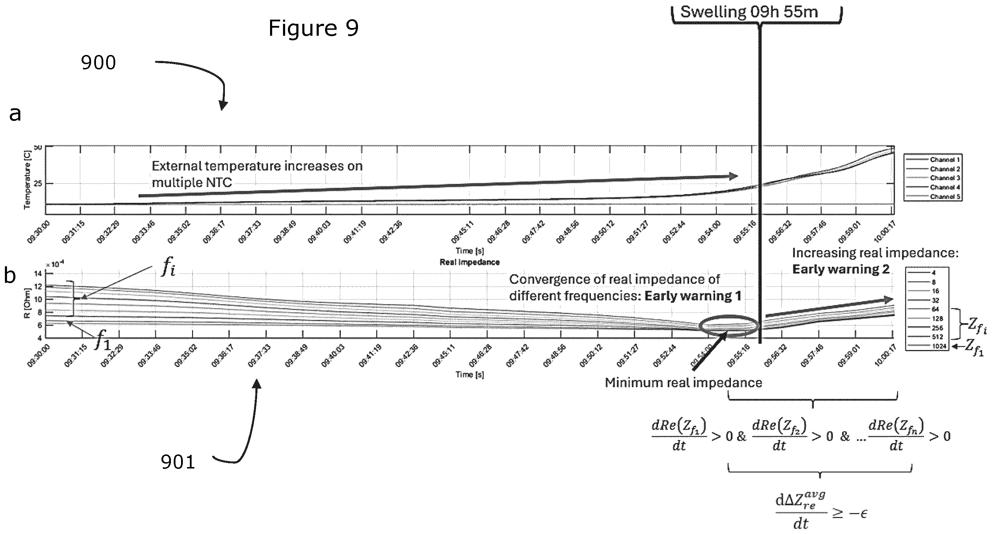

Figure 9a illustrates a graph 900 of external temperature, against time, for a battery cell that was subjected to overcharging for a period of time. The graph 900 shows the temperature measured by a plurality of negative-temperature-coefficient thermistors, NTCs, each configured to measure an external temperature of the battery cell. The battery cell was overcharged to push the battery cell towards thermal runaway. The graph 900 in Figure 9a shows that the temperature of the battery cell increases with time.

Figure 9b illustrates a graph 901 of the real part of the impedance, against time, for the same battery cell across the same period of time as shown in Figure 9a. The graph 901 in Figure 9b shows that the real parts of the impedance of the battery cell at each of the different frequencies converges with time. The convergence triggers a first early warning of thermal runaway. The real parts of the impedances converge to a minimum real impedance. Shortly after the convergence of the real impedances to the minimum real impedance, swelling of the battery cell is detected (as observed with a high-speed camera during the experiments). Subsequent to the first early warning, the real parts of the impedances increase, triggering a second early warning of thermal runaway.

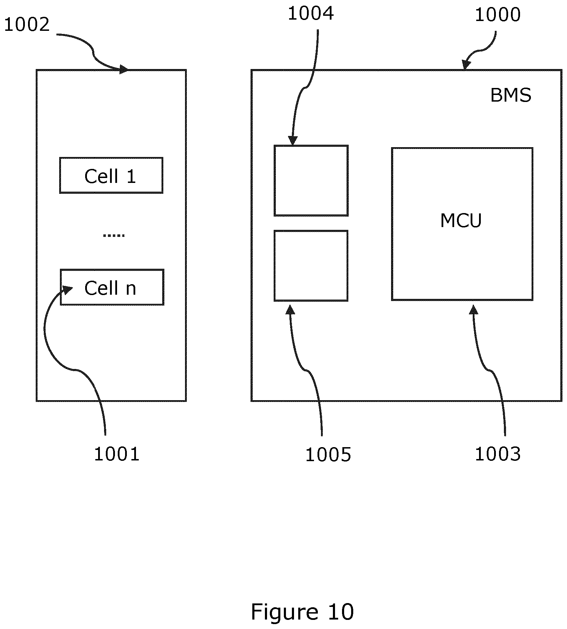

Figure 10 is a schematic diagram of a battery management system 1000, BMS, for managing one or more battery cells 1001. In this example, the one or more battery cells 1001 form a battery pack 1002 that may be used to provide power to an electric vehicle. The battery management system 1000 comprises circuitry and/or one or more modules (which may be hardware and / or software) configured to perform a method of providing an early warning of thermal runaway in the one or more battery cells, as described above in relation to previous figures.

Once a single battery cell of a battery pack has gone in thermal runaway, runaway propagation can occur, which in turn makes the battery pack level experience a thermal event. The method of the present disclosure may be performed on each battery cell of the battery pack to provide an early warning of which of the battery cells will start going into "thermal runaway", such that action can be taken in view of the warning.

In this example, the battery management system 1000 comprises a microcontroller unit 1003. The battery management system 1000 further comprises hardware 1004 configured to perform electrochemical impedance spectroscopy on the one or more battery cells, including a potentiostat, or alternatively a galvanostat, configured to apply the plurality of test signals to the one or more battery cells 1001. The battery management system 1000 further comprises a thermal management module 1005 configured to monitor the temperature of the one or more battery cells 1001.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer-usable storage medium or media is (are) considered to be part of an article (or article of manufacture). An article or article of manufacture can refer to any manufactured single component or multiple components. The non-transient machine or computer-usable media or mediums as defined herein excludes signals, but such media or mediums may be capable of receiving and processing information from signals and/or other transient mediums.

Example embodiments of the material discussed in this specification can be implemented in whole or in part through network, computer, or data-based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. A method of providing an early warning of thermal runaway in a battery cell, the method comprising:
monitoring, over time, a temperature of the battery cell;
monitoring, over time, a real part of an impedance of the battery cell for a plurality of test signal frequencies by:
applying a plurality of test signals to the battery cell at each of a plurality of discrete time intervals, each of the plurality of test signals having a corresponding one of the plurality of test signal frequencies; and
determining, for each applied test signal, the real part of the impedance of the battery cell;
determining, over time, whether the temperature of the battery cell is increasing;
determining, over time, whether the real parts of the impedances corresponding to the plurality of test signal frequencies have converged; and
providing a first warning if the real parts of the impedances at the plurality of test signal frequencies have converged and the temperature has been increasing for a first predetermined number of the discrete time intervals.

2. The method of claim 1, the method further comprising:
after providing the first warning, determining, over time, whether the real parts of cell impedances corresponding to the plurality of test signal frequencies are increasing; and
providing a second warning if the real parts of cell impedances corresponding to the plurality of test signal frequencies have been increasing and the temperature has been increasing for a second predetermined number of the discrete time intervals.

3. The method of claim 2, wherein the method further comprises:
determining, over time, whether the real parts of cell impedances corresponding to the plurality of test signal frequencies are increasing by determining derivatives, with respect to time, of the real parts of the impedances corresponding to each of the plurality of test signal frequencies; and
providing a second warning if the derivatives, with respect to time, of the real parts of the impedances corresponding to each of the plurality of test signal frequencies have been greater than zero and the temperature has been increasing for a second predetermined number of the discrete time intervals.

4. The method of any preceding claim wherein the method further comprises determining the plurality of test signal frequencies by:
determining an impedance response of a reference battery cell at a reference temperature where no heating takes place, the impedance response defining an impedance of the reference battery cell at a plurality of signal frequencies; and
selecting, based on the impedance response, the plurality of test signal frequencies comprising:
a reference frequency corresponding to a frequency at which the imaginary part of the impedance response of the reference cell is approximately zero; and
one or more additional signal frequencies, the one or more additional frequencies being lower in frequency than the first reference frequency.

5. The method of claim 4, wherein the one or more additional frequencies of the plurality of test signal frequencies are frequencies characteristic of a semi-circle region on a Nyquist plot of the impedance response of the reference battery cell at a reference temperature.

6. The method of claim 4 or 5, wherein the one or more additional frequencies of the plurality of test signal frequencies comprise three or more distinct frequencies.

7. The method of any of claims 4-6, wherein determining an impedance response of the reference battery cell comprises performing an electrochemical impedance spectroscopy, EIS, analysis on the reference battery cell.

8. The method of any of claims 4-7, wherein monitoring, over time, the real part of the impedance of the battery cell for each of the plurality of test signal frequencies comprises:
applying the plurality of test signals to the battery cell at a plurality of discrete time intervals, the plurality of test signals having the plurality of test signal frequencies;
determining the real part of an impedance corresponding to a reference frequency; and
determining the real part of one or more impedances corresponding to the one or more additional frequencies; and
wherein determining, over time, whether the real parts of the impedances corresponding to the plurality of test signal frequencies have converged comprises:
determining, at each discrete time interval, a mean average of the absolute differences between the real part of the impedance corresponding to the reference frequency and the real part of the one or more impedances corresponding to the one or more additional frequencies; and
wherein the method comprises providing the first warning if the mean average stays approximately constant or is rising over time while the temperature has been increasing for a first predetermined number of the discrete time intervals.

9. The method of any of claims 4-7, wherein monitoring, over time, a real part of an impedance of the battery cell for each of a plurality of test signal frequencies comprises:
applying the plurality of test signals to the battery cell at a plurality of discrete time intervals, the plurality of test signals having the plurality of test signal frequencies;
determining the real part of an impedance corresponding to a reference frequency; and
determining the real part of one or more impedances corresponding to the one or more additional frequencies; and
wherein determining, over time, whether the real parts of the impedances corresponding to the plurality of test signal frequencies have converged comprises:
determining, for each discrete time interval, a derivative with respect to time of the mean average of the absolute differences between the real part of the impedance corresponding to the reference frequency and the real part of the one or more impedances corresponding to the one or more additional frequencies; and
wherein the method comprises providing the first warning if the derivative has risen above a threshold value and the temperature has been increasing for a first predetermined number of the discrete time intervals.

10. The method of any preceding claim, wherein monitoring, over time, the temperature of the battery cell comprises monitoring an external temperature of the battery at the plurality of discrete time instances.

11. The method of any preceding claim wherein determining, over time, whether the temperature of the battery cell is increasing by determining a derivative with respect to time of the monitored temperature of the battery cell.

12. A battery management system, BMS, for managing one or more battery cells, wherein the BMS is configured to perform the method of any preceding claim on at least one battery cell.

13. The battery management system, BMS, of claim 12, wherein the battery management system, BMS, comprises:
a potentiostat or galvanostat configured to apply the plurality of test signals to the one or more battery cells;
a thermal management module configured to monitor the temperature of the one or more battery cells; and
circuitry configured to perform the method of any preceding claim.

14. A non-transitory computer-readable medium encoding instructions operable to cause a battery management system, BMS, to perform the method of any of claims 1-11.

15. A vehicle comprising the battery management system of any of claims 12-13 and/or the non-transitory computer-readable medium of claim 14.
